# EUROPEAN PATENT APPLICATION

(11) **EP 1 696 663 A1**
(43) Date of publication of application: **30.08.2006**
(21) Application number: 06100738.1
(22) Date of filing: 23.01.2006
(51) Int. Cl.: H04N 5/46, H04N 9/64

(54) **Tuner device and electronic apparatus**

(30) Priority: 25.02.2005 JP 2005051811
(71) Applicant: KABUSHIKI KAISHA TOSHIBA, Tokyo 105-8001 (JP)
(72) Inventor: Oka, Hiroyuki Toshiba Corporation, Tokyo, 105-8001 (JP); Inoue, Yoshinori Toshiba Corporation, Tokyo, 105-8001 (JP)
(74) Representative: Henkel, Feiler & Hänzel

(57) **Abstract**

A tuner device includes a tuner circuit (123) configured to receive a plurality of kinds of broadcast signals corresponding to a plurality of kinds of color systems, and a control unit (216) that inputs region designation information that designates a region where the tuner circuit (123) is used, and fixes, in a case where the region designated by the input region designation information is a specific region, the color system of the broadcast signal, which is received by the tuner circuit (123), to a specific color system that corresponds to the designated region.

## Description

The present invention relates to a tuner device for receiving a broadcast signal and an electronic apparatus.

In recent years, various types of portable personal computers, such as a notebook computer and a laptop computer, have been developed. Recently, in order to improve audio/video (AV) functions in these computers, tuners for receiving broadcast signals, such as TV broadcast signals, have been mounted in the computers more and more.

In many regions of the world, however, various TV standards (color systems) are adopted. For example, the NTSC-M color system is adopted in Japan and North America, while the PAL-BG is used in Germany, etc. In addition, in some regions, broadcast signals corresponding to a plurality of kinds of color systems are used.

Under the circumstances, so-called worldwide tuners, which can receive a plurality of kinds of TV broadcast signals corresponding to a plurality of kinds of color systems, have recently been developed.

USP 6,340,997 discloses a TV tuner that is usable in all countries in the world. This tuner can correctly receive a plurality of kinds of TV broadcast signals corresponding to various TV standards.

In usual cases, a system having the worldwide tuner is provided with an auto-setting function for automatically determining the color system corresponding to a currently received broadcast signal, or a manual setting function for setting a to-be-received color system in the tuner by a user's manual operation.

However, depending on regions, there is a color system, the reception of which is prohibited by law or the like. In this case, there is such a danger that the color system, the reception of which is prohibited, may be received by the auto-setting function or manual setting function. This is a violation of law.

There are many regions where only one kind of color system is supported. In these regions, it is basically impossible to receive broadcast signals of color systems that are different from the color system available in the regions. In these regions, if the color system to be received is erroneously changed to a color system that is not supported in the regions, due to erroneous determination by the auto-setting function or an erroneous operation of the manual setting function by the user, none of the broadcast signals could be received.

The object of the present invention is to provide a tuner device and an electronic apparatus that can prevent such a situation from occurring that a color system, the reception of which is prohibited by law, etc. is received or that none of broadcast signals can be received.

According to an embodiment of the present invention, there is provided a tuner device comprising: a tuner circuit configured to receive a plurality of kinds of broadcast signals corresponding to a plurality of kinds of color systems; and control means for inputting region designation information that designates a region where the tuner circuit is used, and fixing, in a case where the region designated by the input region designation information is a specific region, the color system of the broadcast signal, which is received by the tuner circuit, to a specific color system that corresponds to the designated region.

According to another embodiment of the present invention, there is provided an electronic apparatus that receives a broadcast signal, comprising: a tuner circuit configured to receive a plurality of kinds of broadcast signals corresponding to a plurality of kinds of color systems; an input unit that inputs data which designates a region where the tuner circuit is used; control means for fixing, in a case where the region designated by the input data is a specific region, the color system of the broadcast signal, which is received by the tuner circuit, to a specific color system that corresponds to the designated region; and a display unit that displays video data which is included in the broadcast signal received by the tuner circuit.

This summary of the invention does not necessarily describe all necessary features so that the invention may also be a sub-combination of these described features.

The invention can be more fully understood from the following detailed description when taken in conjunction with the accompanying drawings, in which:
FIG. 1 is a perspective view that schematically shows the external appearance of a computer according to an embodiment of the present invention;
FIG. 2 is a block diagram that shows a system configuration of the computer shown in FIG. 1;
FIG. 3 is a block diagram that shows a functional structure of a TV application program that is used in the computer shown in FIG. 1;
FIG. 4 shows an example of color system information that is used in the computer shown in FIG. 1;
FIG. 5 is a flow chart illustrating the procedure of a region selection process that is executed by the computer shown in FIG. 1;
FIG. 6 is a flow chart illustrating the procedure of a color system fixing process that is executed by the computer shown in FIG. 1;
FIG. 7 is a flow chart illustrating the procedure of a part of a scan process that is executed by the computer shown in FIG. 1;
FIG. 8 is a flow chart illustrating the procedure of the other part of the scan process shown in FIG. 7;
FIG. 9 is a flow chart illustrating the procedure of a part of a manual setting process that is executed by the computer shown in FIG. 1;
FIG. 10 is a flow chart illustrating the procedure of the other part of the manual setting process shown in FIG. 9; and
FIG. 11 shows an example of a setting screen that is used in the computer shown in FIG. 1.

An embodiment of the present invention will now be described with reference to the accompanying drawings.

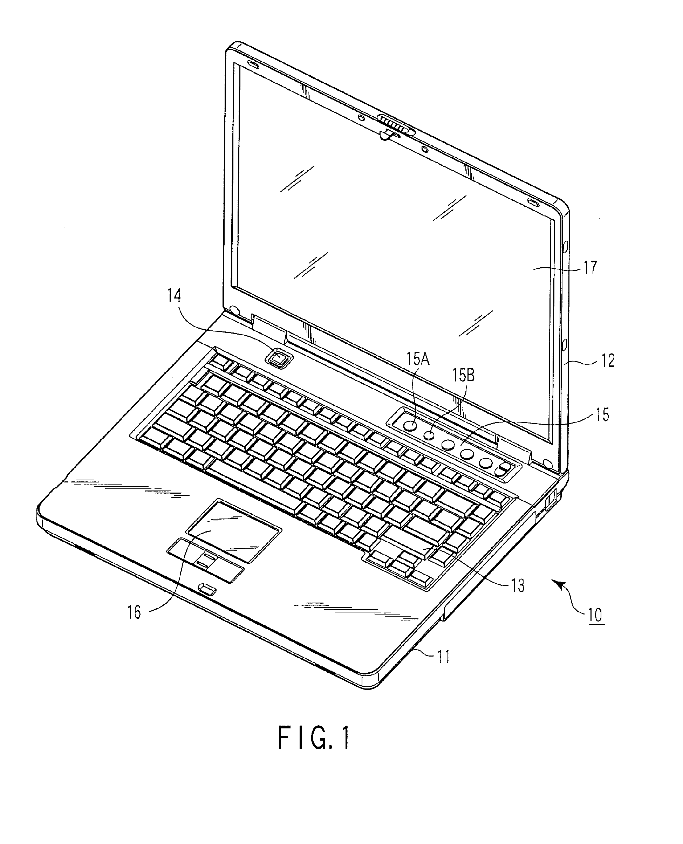

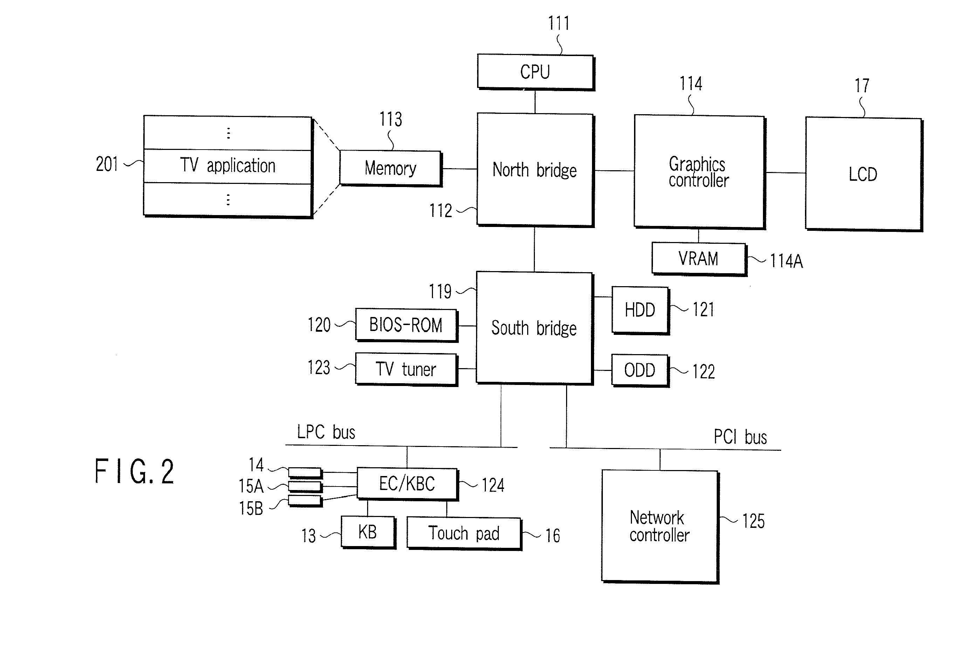

To begin with, referring to FIG. 1 and FIG. 2, the structure of an electronic apparatus according to an embodiment of the invention is described. The electronic apparatus is a portable electronic apparatus having a tuner circuit, and is realized, for example, as an information processing apparatus such as a notebook personal computer 10.

FIG. 1 is a perspective view that shows the state in which a display unit of the notebook personal computer 10 is opened. The computer 10 comprises a computer main body 11 and a display unit 12. A display device that is composed of a TFT-LCD (Thin Film Transistor Liquid Crystal Display) 17 is built in the display unit 12. The display screen of the LCD 17 is positioned at an approximately central part of the display unit 12.

The display unit 12 is attached to the computer main body 11 such that the display unit 12 is freely rotatable between an open position and a closed position. The computer main body 11 has a thin box-shaped casing. A keyboard 13, a power button 14 for powering on/off the computer 10, an input operation panel 15 and a touch pad 16 are disposed on the top surface of the computer main body 11.

The input operation panel 15 is an input device that inputs an event corresponding to a pressed button. The input operation panel 15 has a plurality of buttons for activating a plurality of functions. The buttons include a TV activation button 15A and a DVD/CD activation button 15B. The TV activation button 15A is a button for activating a TV function for reproducing and recording TV broadcast program data. When the TV activation button 15A is pressed by the user, a TV application program for executing the TV function is automatically started.

In this computer 10, a general-purpose main operating system and a purpose-specific sub-operating system for processing AV (audio/video) data are installed. The TV application program is a program that runs on the sub-operating system.

When the power button 14 is pressed by the user, the main operating system is booted up. On the other hand, when the TV activation button 15A is pressed by the user, the sub-operating system, and not the main operating system, is booted up, and the TV application program is automatically executed. The sub-operating system has only a minimum function for executing the AV function. The time that is needed to boot up the sub-operating system is much shorter than the time that is needed to boot up the main operating system. Thus, only by pressing the TV activation button 15A, the user can immediately start TV viewing/recording.

The DVD/CD activation button 15B is a button for reproducing video content that is recorded on a DVD or a CD. When the DVD/CD activation button 15B is pressed by the user, a video reproduction application program for reproducing video content is automatically started. The video reproduction application program, too, is an application program that runs on the sub-operating system. When the DVD/CD activation button 15B is pressed by the user, the sub-operating system, and not the main operating system, is booted up, and the video reproduction application program is automatically executed.

Next, referring to FIG. 2, the system configuration of the computer 10 is described.

The computer 10, as shown in FIG. 2, comprises a CPU 111, a north bridge 112, a main memory 113, a graphics controller 114, a south bridge 119, a BIOS-ROM 120, a hard disk drive (HDD) 121, an optical disc drive (ODD) 122, a TV tuner circuit 123, an embedded controller/keyboard controller IC (EC/KBC) 124, and a network controller 125.

The CPU 111 is a processor that is provided in order to control the operation of the computer 10. The CPU 111 executes the main operating system/sub-operating system and various application programs such as a TV application program 201, which are loaded from the hard disk drive (HDD) 121 into the main memory 113.

The TV application program 201 has functions of controlling the TV tuner circuit 123 and reproducing broadcast program data that is included in a TV broadcast signal received by the TV tuner circuit 123. The TV application program 201 also has a function of prompting the user to designate a region (country) where the computer 10 is used, that is, a region where the TV tuner circuit 123 is used, and a function of determining, in accordance with the designated region, whether the TV broadcast signal, which is received by the TV tuner circuit 123, is to be fixed to a specific color system corresponding to the designated region. If the designated region is a region supporting only one kind of color system, the TV application program 201 fixes the TV broadcast signal, which is received by the TV tuner circuit 123, to the color system corresponding to the designated region. In addition, in the case where the designated region is a region where reception of color systems other than the color system corresponding to this region is prohibited by law, etc., the TV application program 201 fixes the TV broadcast signal, which is received by the TV tuner circuit 123, to the color system corresponding to the designated region. Once the color system is fixed, the color system to be received by the TV tuner circuit 123 cannot be changed, unless the user alters the region where the TV tuner circuit 123 is used. In the computer 10, the keyboard (KB) 13 is used as an input unit for inputting data for designating the region where the TV tuner circuit 123 receives broadcast signals.

In addition, the CPU 111 executes a system BIOS (Basic Input/Output System) that is stored in the BIOS-ROM 120. The system BIOS is a program for hardware control.

The north bridge 112 is a bridge device that connects a local bus of the CPU 111 and the south bridge 119. The north bridge 112 includes a memory controller that access-controls the main memory 113. The north bridge 112 has a function of executing communication with the graphics controller 114 via, e.g. an AGP (Accelerated Graphics Port) bus.

The graphics controller 114 is a display controller for controlling the LCD 17 that is used as a display monitor of the computer 10. The graphics controller 114 causes the LCD 17 to display video data, which is written in a video memory (VRAM) 114A. Video data of broadcast program data, which is included in the TV broadcast signal received by the TV tuner circuit 123, is written in the video memory (VRAM) 114A under the control of the CPU 111. Thus, the video data of the broadcast program data is displayed on the LCD 17.

The south bridge 119 controls the devices on an LPC (Low Pin Count) bus, and the devices on a PCI (Peripheral Component Interconnect) bus. In addition, the south bridge 119 includes an IDE (Integrated Drive Electronics) controller for controlling the HDD 121 and ODD 122. The south bridge 119 also includes a function of controlling the TV tuner circuit 123 and a function for access-controlling the BIOS-ROM 120.

The HDD 121 is a storage device that stores various software and data. The optical disc drive (ODD) 122 is a drive unit for driving storage media, such as a DVD or a CD, on which video content is stored.

The TV tuner circuit 123 is a worldwide TV tuner, and supports a plurality of kinds of color systems (TV broadcast standards) such as NTSC-M, PAL-/I, PAL-B/G, SECAM-L/L' and PAL-D/D. The TV tuner circuit 123 can receive a plurality of kinds of TV broadcast signals corresponding to the plural kinds of color systems. Specifically, the TV tuner circuit 123 is configured to be tunable to various TV broadcast signal frequencies corresponding to the plural kinds of color systems, and to be able to execute a demodulation operation corresponding to the color system of the received TV broadcast signal.

The embedded controller/keyboard controller IC (EC/KBC) 124 is a 1-chip microcomputer in which an embedded controller for power management and a keyboard controller for controlling the keyboard (KB) 13 and touch pad 16 are integrated. The embedded controller/keyboard controller IC (EC/KBC) 124 has a function of powering on/off the computer 10 in response to the user's operation of the power button 14. Further, the embedded controller/keyboard controller IC (EC/KBC) 124 is capable of powering on the computer 10 in response to the user's operation of the TV activation button 15A or DVD/CD activation button 15B. The network controller 125 is a communication device that executes communication with an external network such as the Internet.

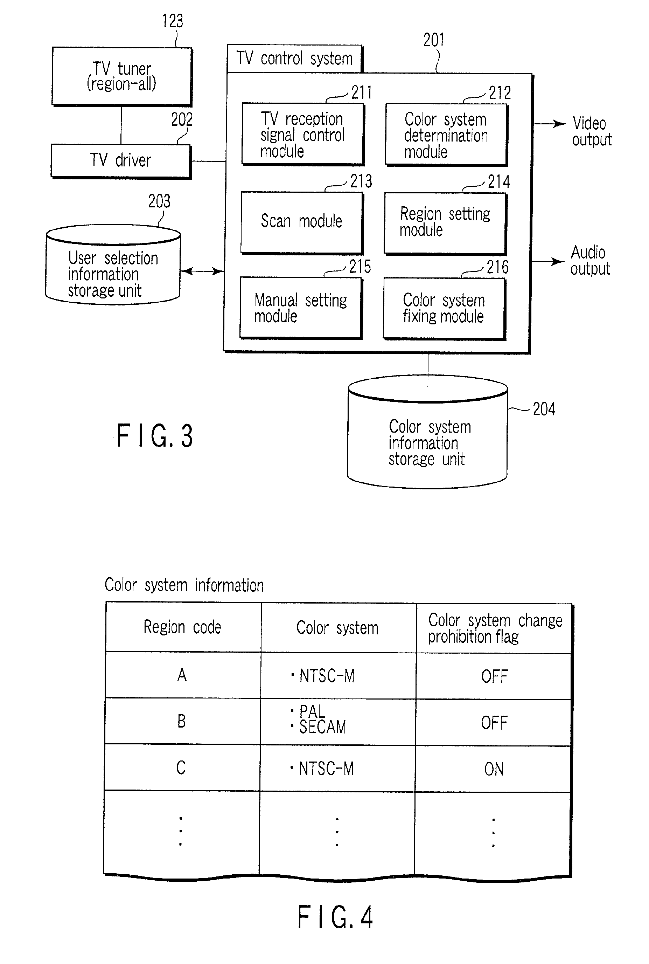

Next, the structure of a TV control system that is realized by the TV application program 201 is described with reference to FIG. 3.

The TV application program 201 controls the TV tuner circuit 123 via a TV driver program 202. As shown in FIG. 3, the TV application program 201 includes, as TV control modules for controlling the TV tuner circuit 123, a TV reception signal control module 211, a color system determination module 212, a scan module 213, a region setting module 214, a manual setting module 215 and a color system fixing module 216.

A broadcast signal that is received by the TV tuner circuit 123 is sent to the TV reception signal control module 211 via the TV driver program 202. Under the control of the TV reception signal control module 211, various control processes are executed with respect to the broadcast signal that is to be received by the TV tuner circuit 123. The color system determination module 212 executes a process for determining the kind of the color system of the broadcast signal that is received by the TV tuner circuit 123.

The scan module 213 executes a scan process for scanning broadcast signal frequencies that correspond to a plurality of kinds of color systems supported by the TV tuner circuit 123, and detecting the frequencies of broadcast signals that are currently receivable by the TV tuner circuit 123 and the kinds of color systems of broadcast signals that are currently receivable by the TV tuner circuit 123. The region setting module 214 executes a region setting process for prompting the user to designate a region where the TV tuner circuit 123 receives broadcast signals, that is, a region where the computer 10 is used. Region designation information (region code or country code) that is indicative of the region designated by the user is stored in a user selection information storage unit 203.

The manual setting module 215 executes a manual setting process for prompting the user to execute a process for setting the frequency and color system in association with each of channels. In the manual setting process, a list of selectable color system candidates is displayed. In accordance with the user's operation, a process is executed for selecting a color system, which is to be received by the TV tuner circuit 123, from the list of color system candidates.

In the case where the region that is designated by the user is a specific region, the color system fixing module 216 executes a process of fixing the color system of the broadcast signal, which is received by the TV tuner circuit 123, to a specific color system corresponding to the designated region, by referring to color system information that is stored in a color system information storage unit 204. Thereby, a change to another color system is prohibited. The specific region is a region where a plurality of color systems are not available, for example, a region where a change of the color system is prohibited by law or the like. By the color system fixing function of the color system fixing module 216, it becomes possible to prevent reception of a broadcast program, the viewing/listening of which is prohibited by law or the like. A region where only one kind of color system is receivable may also be determined to be the above-described specific region. This prevents such a situation from occurring that a color system, which is not receivable, is erroneously selected, with the result that none of broadcast programs can be viewed/listened to.

FIG. 4 shows an example of the color system information.

The color system information indicates the relationship between a plurality of regions and the kinds of color systems that are receivable in the respective regions. In the color system information, color system change prohibition flags are also defined. Each of these flags indicates whether reception of color systems other than the color system corresponding to each region is prohibited. If the color system change prohibition flag is "ON", this means that the reception of other color systems is prohibited. The color system fixing module 216 refers to the color system information shown in FIG. 4, and determines whether the region designated by the user is the above-mentioned specific region or not.

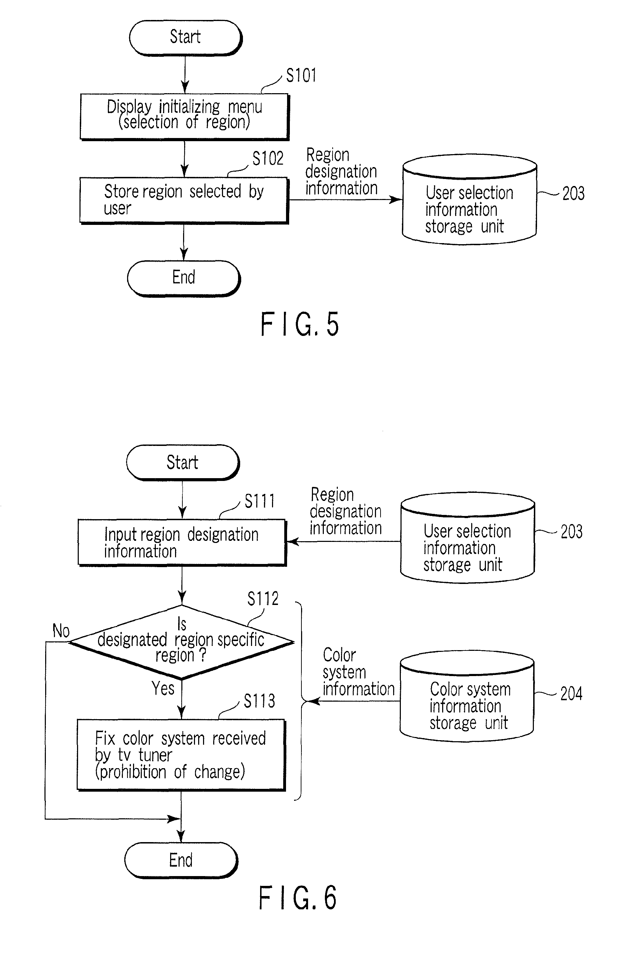

Next, referring to a flow chart of FIG. 5, the procedure of the region setting process, which is executed by the region setting module 214, is described.

For example, at the time of system initialization of the computer 10 (e.g. at a time of first activation, or at a time of recovery), the region setting module 214 causes the LCD 17 to display an initializing menu for prompting the user to select a region for TV viewing/listening (step S101). The user operates the keyboard 13 to select one of many regions that are displayed on the initializing menu. The region setting module 214 stores a region code, which indicates the region selected by the user, in the user selection information storage unit 203 as region designation information that designates the region where the TV tuner circuit 123 receives broadcast signals, that is, the region where the TV tuner circuit 123 is used (step S102).

The above-described region setting process may also be executed while the system is being operated, for example, by calling a setup menu that is provided by the TV application program 201.

Next, referring to a flow chart of FIG. 6, the color system fixing process, which is executed by the color system fixing module 216, is described.

Each time the region setting process is executed, the color system fixing module 216 executes the following process. To start with, the color system fixing module 216 inputs the region designation information from the user selection information storage unit 203 (step S111). In accordance with the region designated by the region designation information, the color system fixing module 216 determines whether the color system of the broadcast signal, which is received by the TV tuner circuit 123, is to be fixed to the specific color system. Specifically, the color system fixing module 216 refers to the color system information and determines whether the region, which is designated by the region designation information, is the above-mentioned specific region (i.e. region where a plurality of color systems are not receivable, a single color system is available) (step S112). If the region that is designated by the region designation information is the above-mentioned specific region (YES in step S112), the color system fixing module 216 executes a process for fixing the color system of the broadcast signal, which is received by the TV tuner circuit 123, to the specific color system corresponding to the region designated by the region designation information (step S113). In step S113, the TV tuner circuit 123 is set to be able to receive only the specific color system, the broadcast signal that is receivable by the TV tuner circuit 123 is limited to the specific color system corresponding to the region designated by the region designation information, and execution of an operation for changing the color system to another color system is prohibited.

Next, an example of a specific process for prohibiting the change to another color system is described.

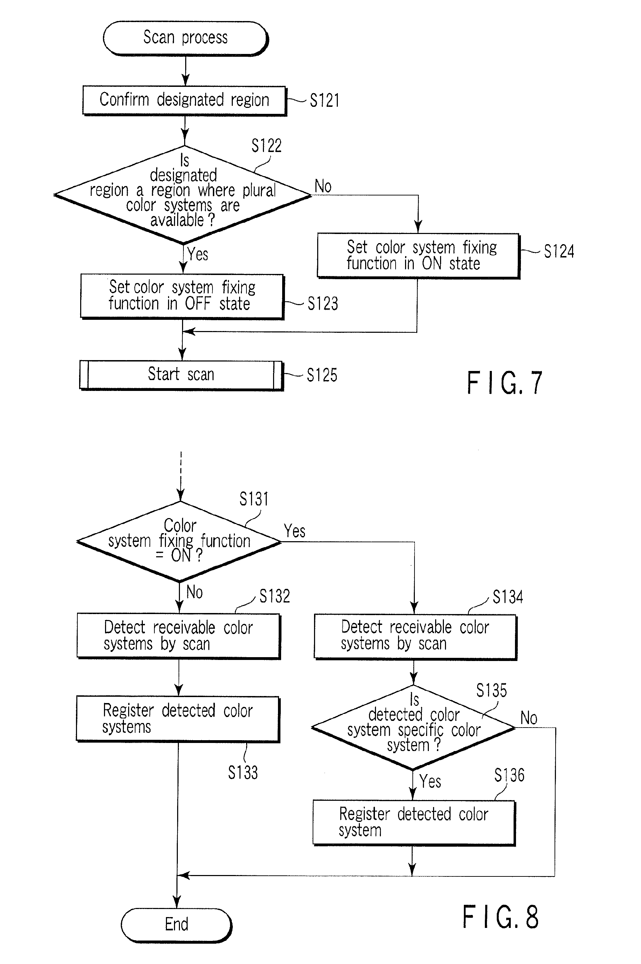

FIG. 7 is a flow chart illustrating the procedure of the scan process that includes a process for prohibiting the change to another color system.

Prior to execution of the scan process, the scan module 213 determines whether the region that is designated by the region designation information is a region where a plurality of color systems are available (step S121, S122). If the designated region is a region where a plurality of color systems are available (YES in step S122), the scan module 213 sets the color system fixing function in the OFF state (step S123). On the other hand, if the designated region is the specific region where a single color system is available (NO in step S122), the scan module 213 sets the color system fixing function in the ON state (step S124). Thereafter, on the basis of the determination result as to whether the designated region is the specific region or not, the scan module 213 executes the scan process (step S125). If the color system fixing function is in the ON state, the color system that is detected by the scan process is limited to the specific color system corresponding to the designated region. FIG. 8 illustrates the procedure of this scan process.

If the color system fixing function is in the OFF state (NO in step S131), the scan module 213 scans broadcast signal frequencies corresponding to a plurality of color systems that are supported by the TV tuner circuit 123, and detects frequencies and color systems of broadcast signals that are currently receivable by the TV tuner circuit 123 (step S132). The scan module 213 stores the detected frequencies and color systems of broadcast signals in the user selection information storage unit 203 as information indicative of receivable broadcast signals (step S133).

On the other hand, if the color system fixing function is in the ON state (YES in step S131), the scan module 213 scans broadcast signal frequencies corresponding to a plurality of color systems that are supported by the TV tuner circuit 123, and detects frequencies and color systems of broadcast signals that are currently receivable by the TV tuner circuit 123 (step S134). The scan module 213 determines, with respect to each of broadcast signals detected in step S134, whether the color system corresponding to the detected broadcast signal is the specific color system corresponding to the designated region (step S315). If the color system corresponding to the detected broadcast signal is the specific color system corresponding to the designated region (YES in step S315), the scan module 213 stores the frequency and color system of the broadcast signal in the user selection information storage unit 203 as information indicative of the receivable broadcast signal (step S136). If the color system corresponding to the detected broadcast signal is not the specific color system corresponding to the designated region (NO in step S315), no storing process is executed with respect to the detected broadcast signal. Thus, the color system detected as the receivable broadcast signal by the scan process is limited to the specific color system corresponding to the designated region.

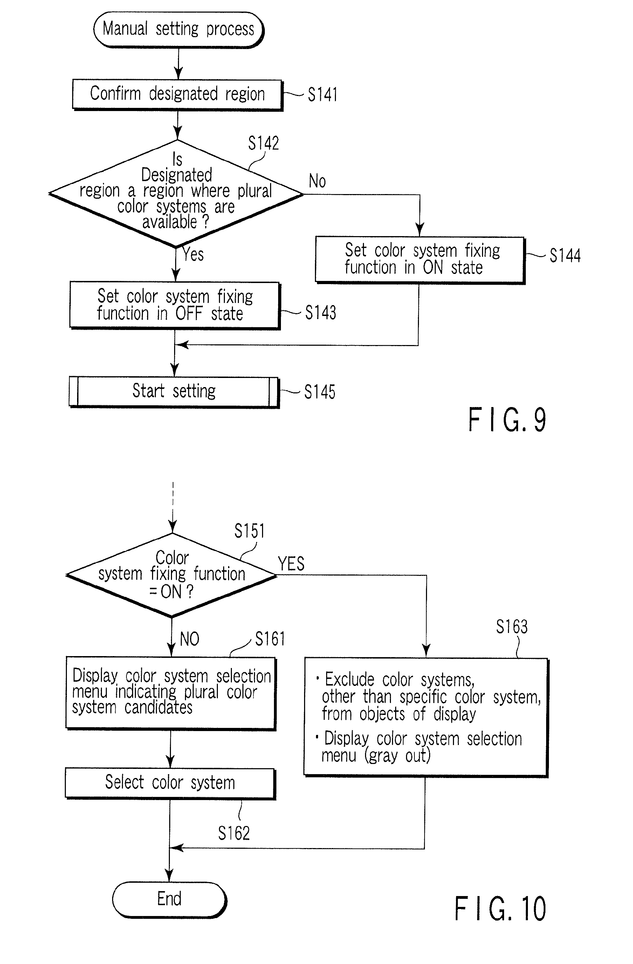

FIG. 9 is a flow chart illustrating the procedure of the manual setting process that includes the process for prohibiting the change to another color system.

When the manual setting function is called by the user, the manual setting module 215 first determines whether the region designated by the region designation information is a region where a plurality of color systems are available (step S141, S142). If the designated region is a region where a plurality of color systems are available (YES in step S142), the manual setting module 215 sets the color system fixing function in the OFF state (step S143). On the other hand, if the designated region is the specific region where a single color system is available (NO in step S142), the manual setting module 215 sets the color system fixing function in the ON state (step S144). Thereafter, on the basis of the determination result as to whether the designated region is the specific region or not, the manual setting module 215 executes the manual setting process for prompting the user to select a color system to be received, from the list of selectable color system candidates (step S145). If the color system fixing function is in the ON state, color systems other than the specific color system corresponding to the designated region are excluded from the selectable color system candidates. FIG. 10 illustrates the procedure of this manual setting.

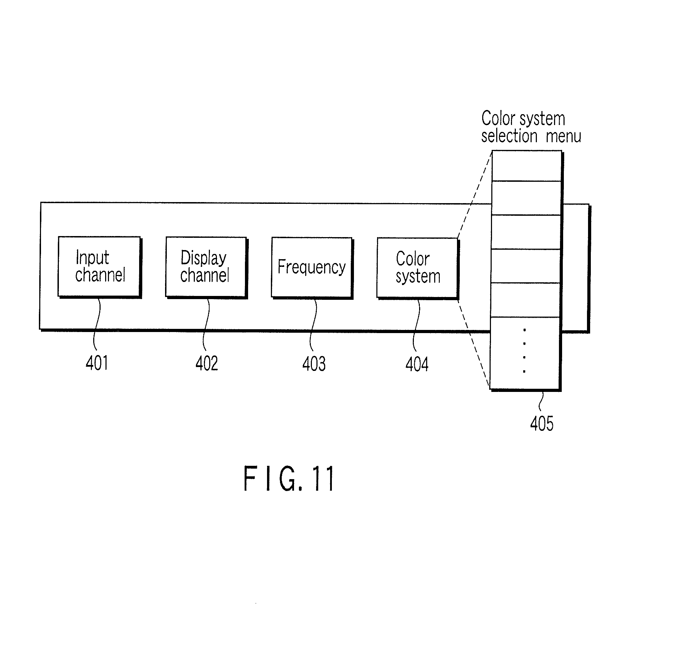

If the color system fixing function is in the OFF state (NO in step S151), the manual setting module 215 displays a color system selection menu, which indicates the list of selectable color system candidates, on the setting screen for individually setting the frequency and color system of each of the channels (step S161). As is shown in FIG. 11, the setting screen includes a button 401 for setting an input channel number, a button 402 for setting a display channel number that is to be assigned to the input channel number, a button 403 for setting the frequency, and a button 404 for setting the color system. When the button 404 is selected by the user through a keyboard or mouse operation, a color system selection menu 405 is displayed. The color system selection menu 405 displays a list of all color systems that are supported by the TV tuner circuit 123. Responding to the user's keyboard or mouse operation, the manual setting module 215 selects one of the color systems from the color system selection menu 405 and stores the selected color system, together with the information indicative of the input channel number, display channel number and the frequency, in the user selection information storage unit 203 (step S162).

On the other hand, if the color system fixing function is in the ON state (YES in step S151), the manual setting module 215 executes a process for excluding all color systems, other than the specific color system corresponding to the designated region, from the selectable color system candidates (step S163). In this case, the button 404 is grayed out. The user cannot select a color system other than the specific color system corresponding to the designated region. In short, in the individual setting process, the change of the color system cannot be executed and the specific color system corresponding to the designated region is always used.

As has been described above, in the present embodiment, when the specific region is designated, the color system of the broadcast signal, which is received by the TV tuner circuit 123, is automatically fixed to the color system corresponding to the designated region, and the change to another color system is prohibited. Therefore, it is possible to prevent such a situation from occurring that a color system, the reception of which is prohibited by law or the like, is received, or none of broadcast signals can be received.

The color system fixing function may also be realized by the tuner device alone, which includes the tuner circuit 123 and the controller or driver program that controls the tuner circuit 123.

The invention is applicable not only to the computer 10, but also to a portable TV receiver, etc.

## Claims

1. A tuner device **characterized by** comprising:
a tuner circuit (123) configured to receive a plurality of kinds of broadcast signals corresponding to a plurality of kinds of color systems; and
control means (216) for inputting region designation information that designates a region where the tuner circuit (123) is used, and fixing, in a case where the region designated by the input region designation information is a specific region, the color system of the broadcast signal, which is received by the tuner circuit (123), to a specific color system that corresponds to the designated region.

2. The tuner device according to claim 1, **characterized in that** the specific region is a region where one of the color systems is available.

3. The tuner device according to claim 1, **characterized by** further comprising means (213) for executing a scan process for scanning frequencies corresponding to the plurality of kinds of broadcast signals, and detecting receivable color systems from the plurality of kinds of color systems,
wherein the control means (216) includes means for controlling, in a case where the region that is designated by the input region designation information is the specific region, the scan process and limiting the receivable color systems, which are detected by the scan process, to the specific color system corresponding to the designated region.

4. The tuner device according to claim 1, **characterized by** further comprising:
means for displaying a list of selectable color system candidates; and
means for selecting a color system, which is to be received by the tuner circuit (123), from the list of the color system candidates,
wherein the control means (216) includes means for executing, in a case where the region that is designated by the input region designation information is the specific region, a process for excluding, from the selectable color system candidates, color systems other than the specific color system corresponding to the designated region.

5. The tuner device according to claim 1, **characterized in that** the control means (216) includes:
means for determining whether a receivable color system in the region designated by the region designation information is a single specific color system, based on color system information that is indicative of a relationship between a plurality of regions and kinds of color systems that are receivable in the plurality of regions; and
means for fixing, in a case where the receivable color system in the region designated by the region designation information is the single specific color system, the color system of the broadcast signal, which is received by the tuner circuit (123), to the single specific color system.

6. The tuner device according to claim 1, **characterized in that** the control means (216) includes:
means for determining, based on color system information including information indicative of a color system corresponding to each of regions and information indicative of whether reception of color systems other than the color system corresponding to each of the regions is prohibited in each of the regions, whether the region, which is designated by the region designation information, is a region where the reception of said other color systems is prohibited; and
means for fixing, in a case where the region designated by the region designation information is the region where the reception of said other color systems is prohibited, the color system of the broadcast signal, which is received by the tuner circuit (123), to the color system corresponding to the region designated by the region designation information, and prohibiting the reception of said other color systems.

7. An electronic apparatus capable of receiving a broadcast signal, **characterized by** comprising:
a tuner circuit (123) configured to receive a plurality of kinds of broadcast signals corresponding to a plurality of kinds of color systems;
an input unit that inputs data which designates a region where the tuner circuit (123) receives the broadcast signal;
control means (216) for fixing, in a case where the region designated by the input data is a specific region, the color system of the broadcast signal, which is received by the tuner circuit (123), to a specific color system that corresponds to the designated region; and
a display unit (17) that displays video data which is included in the broadcast signal received by the tuner circuit (123).

8. The electronic apparatus according to claim 7, **characterized in that** the specific region is a region where one of the color systems is available.

9. The electronic apparatus according to claim 7, **characterized by** further comprising means (213) for executing a scan process for scanning frequencies corresponding to the plurality of kinds of broadcast signals, and detecting receivable color systems from the plurality of kinds of color systems,
wherein the control means (216) includes means for controlling, in a case where the region that is designated by the input data is the specific region, the scan process and limiting the receivable color systems, which are detected by the scan process, to the specific color system corresponding to the designated region.

10. The electronic apparatus according to claim 7, **characterized by** further comprising:
means for displaying a list of selectable color system candidates; and
means for selecting a color system, which is to be received by the tuner circuit (123), from the list of the color system candidates,
wherein the control means (216) includes means for executing, in a case where the region that is designated by the input data is the specific region, a process for excluding, from the selectable color system candidates, color systems other than the specific color system corresponding to the designated region.
